# EUROPEAN PATENT APPLICATION

(11) **EP 3 432 019 A1**
(43) Date of publication of application: **23.01.2019**
(21) Application number: 17182327.1
(22) Date of filing: 20.07.2017
(51) Int. Cl.: G01R 33/483, G01R 33/56, G01R 33/561, G01R 33/565, G01R 33/563

(54) **PARALLEL MULTI-SLICE MR IMAGING USING SIGNAL AVERAGING**

(71) Applicant: Koninklijke Philips N.V., 5656 AE Eindhoven (NL)
(72) Inventor: NISTI GRIGOLETTO BORGONOVI, Arthur Filipe, 5656 AE Eindhoven (NL); JURRISSEN, Michel Paul Jurriaan, 5656 AE Eindhoven (NL); ROZIJN, Thomas Hendrik, 5656 AE Eindhoven (NL)
(74) Representative: de Haan, Poul Erik

(57) **Abstract**

The invention relates to a method of MR imaging of an object (10) placed in an examination volume of a MR device (1). The method comprises the steps of: subjecting the object (10) to an imaging sequence comprising multi-slice RF pulses for simultaneously generating phase-encoded MR signals in two or more spatially separate image slices, wherein the imaging sequence imparts a slice-specific phase modulation to the magnetic resonance signals,acquiring the MR signals, wherein the MR signals are received in parallel via a set of at least two RF coils (11, 12, 13) having different spatial sensitivity profiles within the examination volume, and reconstructing a MR image for each image slice from the acquired MR signals, wherein MR signal contributions from the different image slices are separated on the basis of the spatial sensitivity profiles of the at least two RF coils (11, 12, 13) and on the basis of the phase modulation of the MR signals, wherein MR signal averaging is applied to increase the signal-to-noise ratio of the MR image, with the slice-specific phase modulation being varied from averaging step to averaging step. Moreover, the invention relates to a MR device (1) for carrying out this method as well as to a computer program to be run on a MR device.

## Description

### FIELD OF THE INVENTION

The invention relates to the field of magnetic resonance (MR) imaging. It concerns a method of MR imaging of an object. The invention also relates to a MR device and to a computer program to be run on a MR device.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for imaging of soft tissue they are superior to other imaging methods in many respects, do not require ionizing radiation and are usually not invasive.

According to the MR method in general, the object, for example the body of the patient to be examined, is arranged in a strong, uniform magnetic field whose direction at the same time defines an axis (normally the z-axis) of the co-ordinate system on which the measurement is based. The magnetic field produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse), so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is built up again with a first time constant T₁ (spin lattice or longitudinal relaxation time), and the magnetization in the direction perpendicular to the z direction relaxes with a second time constant T₂ (spin-spin or transverse relaxation time). The variation of the magnetization can be detected by means of receiving RF coils which are arranged and oriented within an examination volume of the MR device in such a manner that the variation of the magnetization is measured in the direction perpendicular to the z-axis. The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing pulse (for example a 180° pulse). This produces an echo signal (spin echo) in the receiving coils.

To realize spatial resolution in the body, constant magnetic field gradients extending along the three main axes are superposed on the uniform magnetic field, leading to a linear spatial dependency of the spin resonance frequency. The signal picked up in the receiving coils then contains components of different frequencies which can be associated with different locations in the body. The signal data obtained via the receiving coils corresponds to the spatial frequency domain and is called k-space data. The k-space data usually includes multiple lines acquired with different phase encoding. Each line is digitized by collecting a number of samples. A set of k-space data is converted to a MR image by means of an image reconstruction algorithm.

Parallel acquisition techniques for accelerating MR acquisition are commonly applied nowadays. Methods in this category are SENSE (Sensitivity Encoding), SMASH (Simultaneous Acquisition of Spatial Harmonics), and GRAPPA (Generalized Auto-calibrating Partially Parallel Acquisition). SENSE, SMASH, and GRAPPA and other parallel acquisition techniques use undersampled k-space data acquisition obtained from multiple RF receiving coils in parallel. In these methods, the (complex) signal data from the multiple coils are combined with complex weightings in such a way as to suppress undersampling artifacts (aliasing) in the finally reconstructed MR images. This type of complex array signal combination is sometimes referred to as spatial filtering, and includes combining which is performed in the k-space domain (as in SMASH and GRAPPA) or in the image domain (as in SENSE), as well as methods which are hybrids.

Larkman et al. (Journal of Magnetic Resonance Imaging, 13, 313-317, 2001) proposed to apply sensitivity encoding also in the slice direction in case of multi-slice imaging to increase scan efficiency. Breuer et al. (Magnetic Resonance in Medicine, 53, 684-691, 2005) improved this basic idea proposing an approach termed "controlled aliasing in parallel imaging results in higher acceleration" (CAIPIRINHA). This technique modifies the appearance of aliasing artifacts in each individual slice during the multi-slice acquisition improving the subsequent parallel image reconstruction procedure. Thus, CAIPIRINHA is a parallel multi-slice imaging technique which is more efficient compared to other multi-slice parallel imaging concepts that use only a pure post-processing approach. In CAIPIRINHA, multiple slices of arbitrary thickness and distance are excited simultaneously with the use of multi-slice RF pulses (similar to the known Hadamard pulses). The acquired MR signal data are under-sampled, yielding superimposed slice images which are back folded due to the reduced field of view. The CAIPIRINHA technique improves the reconstruction by modulating the phase of the MR signals to shift the produced aliasing pattern in the phase-encoding direction. The shift of the aliased slice images is controlled by a phase-modulation scheme of the used RF pulses in accordance with the Fourier shift theorem. A phase shift is imparted to the magnetic resonance signals, which phase shift is linearly incremented from phase-encoding step to phase-encoding step by a slice-specific phase increment. The numerical conditioning of the inverse reconstruction problem, separating the individual signal contributions of the involved slices, is improved by using this shift. CAIPIRINHA has the potential to improve the separation of the superimposed slice images also in cases in which the slices are rather close to each other such that the coil sensitivities of the used RF receiving coils do not differ dramatically in the individual slices to be imaged. However, CAIPIRINHA has limitations.

A drawback of the known CAIPIRINHA technique is that - depending on the used RF coils, the applied acceleration factor of parallel imaging and the image distortion present - unfolding artifacts (signal leakage from one slice to another) can occur, reducing the effectiveness of the method. In particular, such multi-slice unfolding artifacts can lead to misinterpretation of ADC (apparent diffusion coefficient) maps in diffusion-weighted MR imaging.

### SUMMARY OF THE INVENTION

From the foregoing it is readily appreciated that there is a need for an improved parallel multi-slice MR imaging technique. It is thus an object of the invention to enable parallel multi-slice MR imaging with a reduced level of unfolding artifacts.

In accordance with the invention, a method of MR imaging of an object placed in an examination volume of a MR device is disclosed. The method comprises the steps of:
subjecting the object to an imaging sequence comprising multi-slice RF pulses for simultaneously generating phase-encoded MR signals in two or more spatially separate image slices, wherein the imaging sequence imparts a slice-specific phase modulation to the magnetic resonance signals,
acquiring the MR signals, wherein the MR signals are received in parallel via a set of at least two RF coils having different spatial sensitivity profiles within the examination volume, and
reconstructing a MR image for each image slice from the acquired MR signals, wherein MR signal contributions from the different image slices are separated on the basis of the spatial sensitivity profiles of the at least two RF coils and on the basis of the phase modulation of the MR signals,
wherein MR signal averaging is applied to increase the signal-to-noise ratio of the MR image, with the slice-specific phase modulation being varied from averaging step to averaging step.

The technique of the invention generally corresponds to the known CAIPIRINHA approach. The application of relative shifts between the image slices as described above by means of phase-modulating the MR signals increases the effective differences between the coil sensitivities at the locations of voxels that fold together in the superimposed slice images and therefore improves the conditioning of the reconstruction problem. However, according to the invention, no fixed phase-modulation scheme as in CAIPIRINHA is applied. Instead, the phase modulation scheme is varied between different averaging steps. Signal averaging is used as a noise improvement method which is accomplished by taking the average (by complex averaging or modulus averaging) of several MR signals acquired in a number of averaging steps under equal (or at least similar conditions) to suppress the effects of random signal variations or random artifacts. It is an insight of the invention that the level of unfolding artifacts can be significantly reduced by applying signal averaging and by varying the CAIPIRINHA phase modulation from averaging step to averaging step.

In a preferred embodiment of the invention, the phase modulation involves imparting a phase shift to the magnetic resonance signals, which phase shift is linearly incremented from phase-encoding step to phase-encoding step by a slice-specific phase increment. In this case, the phase modulation can be cyclically varied from averaging step to averaging step, for example by starting the phase-cycle with a different phase offset in each averaging step.

In a possible embodiment, the phase shifts may be imparted by means of a phase modulation of the RF pulses (like, for example, in the known POMP technique, see Glover et al., Journal of Magnetic Resonance Imaging 1991, pages 457-461). Alternatively, magnetic field gradient blips applied in a slice direction may be used for imparting the phase offsets (like, e.g., in US 2014/0225612 A1).

In accordance with a preferred embodiment of the invention, the MR signals are acquired with under-sampling in the in-plane direction of the image slices. The MR images of the image slices can be reconstructed in this case by using a per se known parallel image reconstruction algorithm, like SENSE, SMASH or GRAPPA.

The method can advantageously be applied to improve diffusion-weighted multi-slice imaging. In this case, the MR signals are diffusion weighted, wherefore the imaging sequence comprises diffusion-sensitizing gradients and the reconstruction of the MR image involves derivation of diffusion coefficients from the averaged MR signal data. In a typical diffusion-weighted MR imaging method, a baseline MR image (b0 image) is acquired with all diffusion-sensitizing gradients turned off. Immediately thereafter, diffusion gradients are applied individually and in various combinations to produce a set of diffusion-weighted MR images sensitized to diffusion along various directions. At least three sets of diffusion-weighted MR images must be obtained. These may be along the x-, y-, and z-axes or in three arbitrary perpendicular orientations. Some known schemes obtain MR images in 6, 20 or more directions, but three is typically the minimum. From these measurements, a diffusion tensor can be derived indicating the anisotropy of diffusion in the examined tissue. The average of the trace of the diffusion tensor reduces the multi-directional diffusivity at each voxel position into a single number that can be considered a consolidated apparent diffusion coefficient (ADC). It is an insight of the invention that unfolding artifacts in the ADC map can already be reduced to a significant extent when signal averaging (in combination with the above-described variation of the phase modulation) is only applied for the acquisition of the MR signals of the b0 image in which no diffusion gradients are applied. The further multi-slice acquisitions with diffusion-sensitizing gradients being applied in different directions may be performed conventionally without signal averaging to keep the scan time as short as possible. The minor overall increase of scan time for acquiring several averages only for the b0 image can be tolerated in view of the reduced amount of artifacts in the obtained ADC maps.

In order to achieve the effect of the invention to a useful extent, the number of averaging steps should at least equal the number of image slices (i.e. the multi-slice acceleration factor).

The method of the invention described thus far can be carried out by means of a MR device including at least one main magnet coil for generating a uniform static magnetic field within an examination volume, a number of gradient coils for generating switched magnetic field gradients in different spatial directions within the examination volume, a set of RF coils for receiving MR signals from the body in parallel, the RF coils having different spatial sensitivity profiles, a control unit for controlling the temporal succession of RF pulses and switched magnetic field gradients, and a reconstruction unit.

The method of the invention can be implemented, for example, by a corresponding programming of the reconstruction unit and/or the control unit of the MR device.

The method of the invention can be advantageously carried out in most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows a MR device for carrying out the method of the invention;
Fig. 2 illustrates one shot of a multi-slice multi-echo imaging sequence according to the invention;
Fig. 3 shows b0 MR images and ADC maps, acquired without (Fig. 3a) and with (Fig. 3b) the signal averaging approach of the invention.

### DETAILED DESCRIPTION OF THE EMBODIMENTS

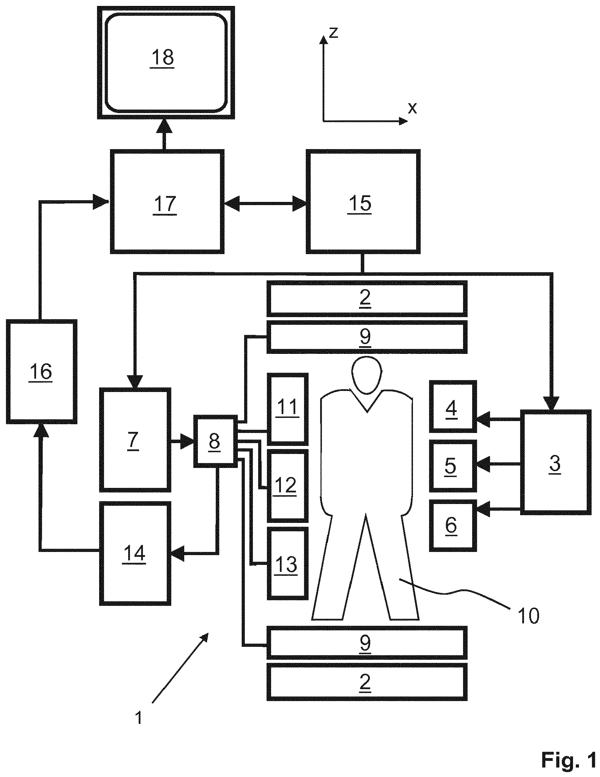

With reference to Fig. 1, a MR device 1 is shown. The device comprises superconducting or resistive main magnet coils 2 such that a substantially uniform, temporally constant main magnetic field is created along a z-axis through an examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a whole-body volume RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume.

For generation of MR images of limited regions of the body 10 by means of parallel imaging, a set of local RF coils 11, 12, 13 are placed contiguous to the region selected for imaging.

The resultant MR signals are picked up by the RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR devices the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

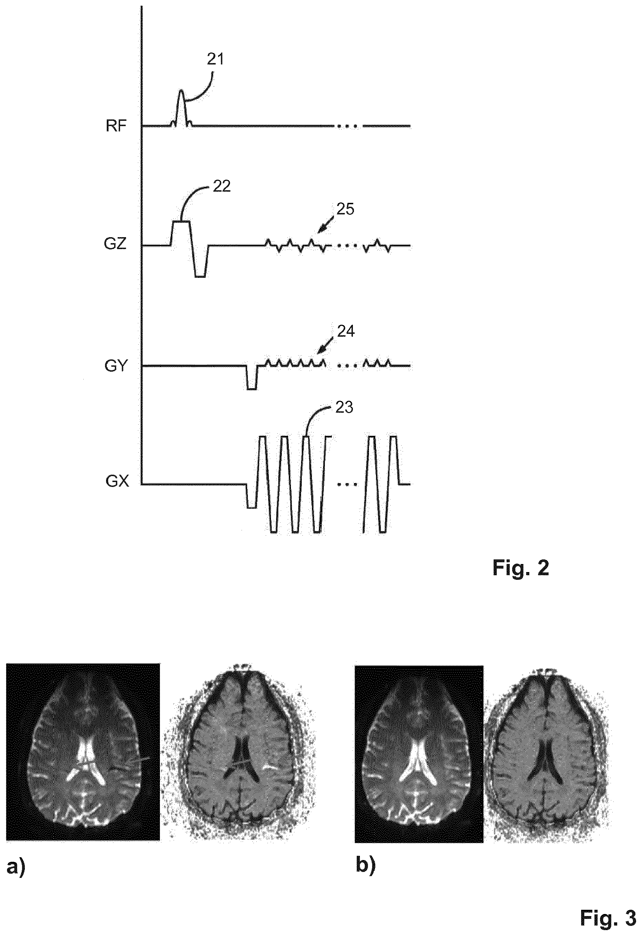

With continuing reference to Fig. 1 and with further reference to Figs. 2 and 3 an embodiment of the imaging approach of the invention is explained.

In a possible embodiment of the invention, the body 10 is subjected to a multi-echo imaging sequence as illustrated in Fig. 2. The imaging sequence is a modified EPI sequence. The sequence comprises a slice-selective multi-slice RF pulse 21 for simultaneously exciting two or more spatially separate image slices. RF pulse 21 is radiated in the presence of a corresponding slice selection magnetic field gradient 22 in order to produce transverse nuclear magnetization in a number of imaging slices. Following excitation RF pulse 21 MR signals are acquired by sampling a series of gradient-recalled echo signals in the presence of an alternating readout magnetic field gradient 23. Phase-encoding of the MR signals is performed by a series of phase-encoding magnetic field gradient 'blips' 24. During the application of each phase encoding gradient blip 24, a further magnetic field gradient blip 25 is also applied in the slice direction. The slice encoding gradient blips 25 are used, like in the conventional CAIPIRINHA scheme, to impart a phase modulation to the MR signals of each image slice. The phase modulation involves imparting a phase shift to the MR signals, which phase shift is linearly incremented from phase-encoding step to phase-encoding step by a slice-specific phase increment. The MR signal acquisition is accelerated by SENSE encoding. The MR signals are acquired in parallel via RF receiving coils 11, 12, 13 having different spatial sensitivities, and the MR signals are acquired with under-sampling in the phase-encoding direction.

According to the invention, MR signal averaging is applied to increase the signal-to-noise ratio of the MR image. To this end, the depicted imaging sequence is repeated a number of times, wherein only the slice-specific CAIPIRINHA phase modulation is varied from averaging step to averaging step. In more detail, the linearly incremented phase shifting is maintained, but the phase modulation is cyclically varied from averaging step to averaging step. For example, in the case of a multi-slice factor of 3 (three image slices are simultaneously acquired) and a CAIPIRINHA shift of 3 (shift of the aliasing pattern by 1/3 of the field of view in the phase-encoding direction), and an acquisition of four signal averages, the following cyclic variation of the phase modulation may be applied:

**Phase-encoding step**

| | | | |
|---|---|---|---|
| (k-space line #): | 1 | 2 | 3 |
| Average #1: | -120° | 0° | 120° |
| Average #2: | 0° | 120° | -120° |
| Average #3: | 120° | -120° | 0° |
| Average #4: | -120 | 0° | 120° |

The MR signals are accumulated using modulus averaging, and an MR image is reconstructed for each image slice from the acquired averaged MR signal data using a parallel reconstruction algorithm, wherein the MR signal contributions from the different image slices are separated on the basis of the spatial encodings of the MR signals according to the (known) spatial sensitivity profiles of the RF coils and on the basis of the CAIPIRINHA shifts attributed to the respective image slices.

Fig. 3a shows an MR image, namely a b0 image of a diffusion imaging scan (left) and a corresponding ADC map (right) obtained with signal averaging, but without the phase modulation scheme of the invention. A number of unfolding artifacts occur (indicated by arrows). Fig 3b shows the corresponding b0 image and the ADC map obtained with the same amount of averaging but using the phase modulation proposed by the invention. No unfolding artifacts can be recognized in Fig. 3b.

## Claims

1. Method of MR imaging of an object (10) placed in an examination volume of a MR device (1), the method comprising the steps of:
subjecting the object (10) to an imaging sequence comprising multi-slice RF pulses for simultaneously generating phase-encoded MR signals in two or more spatially separate image slices, wherein the imaging sequence imparts a slice-specific phase modulation to the magnetic resonance signals,
acquiring the MR signals, wherein the MR signals are received in parallel via a set of at least two RF coils (11, 12, 13) having different spatial sensitivity profiles within the examination volume, and
reconstructing a MR image for each image slice from the acquired MR signals, wherein MR signal contributions from the different image slices are separated on the basis of the spatial sensitivity profiles of the at least two RF coils (11, 12, 13) and on the basis of the phase modulation of the MR signals,
wherein MR signal averaging is applied to increase the signal-to-noise ratio of the MR image, with the slice-specific phase modulation being varied from averaging step to averaging step.

2. Method of claim 1, wherein the phase modulation involves imparting a phase shift to the magnetic resonance signals, which phase shift is linearly incremented from phase-encoding step to phase-encoding step by a slice-specific phase increment.

3. Method of claim 2, wherein the phase modulation is cyclically varied from averaging step to averaging step.

4. Method of claim 2 or 3, wherein the phase shift is imparted by means of a phase modulation of the multi-slice RF pulses.

5. Method of claim 2 or 3, wherein the phase shift is imparted by means of magnetic field gradient blips (25) applied in the slice direction.

6. Method of any one of claims 1-5, wherein the MR signals are acquired with under-sampling in the in-plane direction of the image slices, wherein the MR image is reconstructed using a parallel image reconstruction algorithm, like SENSE, SMASH or GRAPPA.

7. Method of any one of claims 1-6, wherein the MR signals are diffusion weighted wherefore the imaging sequence comprises diffusion gradients.

8. Method of claim 7, wherein the reconstruction of the MR image involves derivation of diffusion coefficients from the averaged MR signal data.

9. Method of claim 8, wherein the MR signal acquisition and MR image reconstruction steps are repeated two or more times with different diffusion gradients being applied in the different repetitions.

10. Method of claim 9, wherein MR signal averaging is applied only during the acquisition of MR signals of a baseline MR image in which no diffusion gradients are applied.

11. Method of any one of claims 1-10, wherein the number of averaging steps at least equals the number of image slices.

12. MR device for carrying out the method claimed in claims 1-11, which MR device (1) includes at least one main magnet coil (2) for generating a uniform, static magnetic field within an examination volume, a number of gradient coils (4, 5, 6) for generating switched magnetic field gradients in different spatial directions within the examination volume, at least two RF coils (11, 12, 13) having different spatial sensitivity profiles, a control unit (15) for controlling the temporal succession of RF pulses and switched magnetic field gradients, and a reconstruction unit (17), wherein the MR device (1) is arranged to perform the following steps:
subjecting an object (10) to an imaging sequence comprising multi-slice RF pulses for simultaneously generating phase-encoded MR signals in two or more spatially separate image slices, wherein the imaging sequence imparts a slice-specific phase modulation to the magnetic resonance signals,
acquiring the MR signals, wherein the MR signals are received in parallel via a set of at least two RF coils (11, 12, 13) having different spatial sensitivity profiles within the examination volume, and
reconstructing a MR image for each image slice from the acquired MR signals, wherein MR signal contributions from the different image slices are separated on the basis of the spatial sensitivity profiles of the at least two RF coils (11, 12, 13) and on the basis of the phase modulation of the MR signals,
wherein MR signal averaging is applied to increase the signal-to-noise ratio of the MR image, with the slice-specific phase modulation being varied from averaging step to averaging step.

13. Computer program to be run on a MR device, which computer program comprises instructions for:
executing an imaging sequence comprising multi-slice RF pulses for simultaneously generating phase-encoded MR signals in two or more spatially separate image slices, wherein the imaging sequence imparts a slice-specific phase modulation to the magnetic resonance signals,
acquiring the MR signals, wherein the MR signals are received in parallel via a set of at least two RF coils (11, 12, 13) having different spatial sensitivity profiles within the examination volume, and
reconstructing a MR image for each image slice from the acquired MR signals, wherein MR signal contributions from the different image slices are separated on the basis of the spatial sensitivity profiles of the at least two RF coils (11, 12, 13) and on the basis of the phase modulation of the MR signals
wherein MR signal averaging is applied to increase the signal-to-noise ratio of the MR image, with the slice-specific phase modulation being varied from averaging step to averaging step.
